Europäisches Patentamt

European Patent Office

Office européen des brevets

(11) Veröffentlichungsnummer: **0 197 323**
**A2**

## (12) EUROPÄISCHE PATENTANMELDUNG

(21) Anmeldenummer: 86103103.7

(22) Anmeldetag: 08.03.86

(51) Int. Cl.⁴: **H05K 1/00** , H05K 3/38 , H05K 3/18

(30) Priorität: 21.03.85 DE 3510201

(43) Veröffentlichungstag der Anmeldung:
**15.10.86 Patentblatt 86/42**

(84) Benannte Vertragsstaaten:
**AT BE CH DE FR GB IT LI NL SE**

(71) Anmelder: **BAYER AG**
**Konzernverwaltung RP Patentabteilung**
**D-5090 Leverkusen 1 Bayerwerk(DE)**

(72) Erfinder: **Sirinyan, Kirkor, Dr.**
**Humperdinckstrasse 12**
**D-5060 Bergisch Gladbach 2(DE)**
Erfinder: **Wolf, Gerhard Dieter, Dr.**
**Wilhelm-Busch-Strasse 29**
**D-4047 Dormagen 5(DE)**
Erfinder: **von Gizycki, Ulrich, Dr.**
**Wiembachallee 24**
**D-5090 Leverkusen 3(DE)**
Erfinder: **Merten, Rudolf, Dr.**
**Berta-von-Suttner-Strasse 55**
**D-5090 Leverkusen(DE)**

(54) **Elektrische Leiterplatten.**

(57) Elektrische Leiterplatten bestehend im wesentlichen aus dem Basismaterial und dem naßchemisch unter Verwendung von Aktivatorsystemen, nach den Prinzipien der Semi-oder Volladditivtechnik aufgebrachten Leiterbild, dadurch gekennzeichnet, daß die Aktivatoren fein verteilte Metalle oder anorganische ionogene Verbindungen von Elementen der 1. oder 8. Nebengruppe des periodischen Systems sind und daß die Oberfläche des Basismaterials charakterisiert ist durch

a) ein flächenbezogenes spezifisches Gesamtporenvolumen von 0,015-0,045 dm³/m²
b) einen mittleren Porendurchmesser von 0,05-12,0 $\mu$m und
c) eine mittlere Porentiefe von 0,05-4,0 $\mu$m.

EP 0 197 323 A2

## Elektrische Leiterplatten

Es ist allgemein bekannt, daß man zur Herstellung von elektrischen Leiterplatten in metallkaschierten oder metalllaminierten Isolierbasismaterialien Bohrungen anbringt, die Bohrlöcher auf chemischem Wege durchkontaktiert, die Substratoberfläche mit einer Maske bedeckt, die freie Metalloberfläche auf galvanischem Wege mit einem ätzmittelbeständigen Metallresist versieht, die Maske in einem geeigneten Medium von der Substratoberfläche entfernt und dann die Grundmetallschicht wegätzt. Die zur Durchführung dieses Verfahrens - (Subtraktiv-Verfahren) eingesetzten Metallauflagen bestehen in den meisten Fällen aus reinem Elektrolytkupfer und haben eine Schichtdicke von 17,5 bis 70 $\mu$m.

Die bekannten Subtraktiv-Verfahren haben nicht nur den Nachteil, daß sie aus mehreren Teilschritten bestehen, sondern sie führen im letzten Schritt zur Unterätzung der Leiterbahnen.

Ein weiterer Nachteil der bekannten Verfahren besteht darin, daß sie Metallresists erfordern.

Beim Aufbringen der Metallresistauflage kann das galvanisch aufwachsende Metallresist auch seitlich "auswuchern". Man spricht von "Überplattierung" oder auch "Pilzbildung" der Leiterbahnen, was sich auf die im Querschnitt zu sehende pilzähnliche Form und die geringe Tiefenschärfe bezieht. Dieser unerwünschte Effekt wird durch das nachfolgende Wegätzen der Grundkupferschicht noch weiter verstärkt. Um die besagte "Überplattierung" oder "Pilzbildung" zu vermeiden, müssen mechanisch stabile und dicke Folienresiste verwendet werden.

Solche mechanisch stabilen Folienresiste sollen sowohl die Kupferleiter als auch das Resistmetall "kanalisieren" und somit die Pilzbildung vermeiden.

Ein weiterer sehr großer Nachteil der Metallresiste besteht darin, daß sie beim Löten schmelzen und zum bekannten Apfelsinenhauteffekt führen. Besonders bei hochwertigen Leiterplatten kann dieser Effekt nicht akzeptiert werden. Als weiterer Nachteil des Subtraktivverfahrens sei erwähnt, daß es zur Herstellung von Feinleiterplatten mit einer Leiterbahnbreite von $\leq$ 100 $\mu$m aus den genannten Gründen nicht geeignet ist.

Um die angegebenen Nachteile zu vermeiden, wurde bereits versucht, die sogenannten Semiadditiv-und Volladditiv-Verfahren zu entwickeln. Zur Durchführung dieser Verfahren ist das Aufbringen einer dünnen, gut haftenden, lötbadstabilen, elektrisch-leitfähigen Metallauflage von größter Wichtigkeit.

Es ist weiterhin bekannt, daß die Abscheidung von haftfesten Metallauflagen auf den üblichen Isolierbasismaterialien eine aufwendige Vorbehandlung erfordert. So müssen beispielsweise die Basisplatten aus glasmattenverstärkten Epoxidharzen oder papierverstärkten Phenolharzen zur Herstellung von Leiterplatten zunächst mit einer Haftvermittlerschicht versehen und anschließend mit einer oxidierenden Flüssigkeit, vorzugsweise Chromschwefelsäure, behandelt werden, bevor die so präparierten Platten mit ionischen oder kolloidalen Edelmetalllösungen aktiviert, maskiert und in handelsüblichen Metallisierungsbädern metallisiert werden.

Abgesehen von der Vielstufigkeit dieser Methoden weist diese Technik den Nachteil auf, daß eingeschleppte Chromionen die Bäder irreversibel vergiften und daß die erhaltenen Leiterplatten unbefriedigende elektrische Eigenschaften zeigen.

Es wurde nun gefunden, daß man diese Nachteile vermeidet und auf einfache Weise, d.h. ohne Ätzung und ohne Haftvermittlerschicht, mittels einer Semi-oder Volladditivtechnik unter Verwendung von Aktivatorsystemen auf der Basis von fein verteilten Metallen oder anorganischen ionogenen Verbindungen der Elemente der 1. oder 8. Nebengruppe des periodischen Systems zu hochwertigen Leiterplatten gelangt, wenn man als Basismaterial ein solches verwendet, dessen Oberfläche charakterisiert ist durch

a) ein flächenbezogenes spezifisches Gesamtporenvolumen von 0,015-0,045 dm³/m²

b) einen mittleren Porendurchmesser von 0,05-12,0 $\mu$m und

c) eine mittlere Porentiefe von 0,05-12,0 $\mu$m.

Das bevorzugte Porenvolumen liegt zwischen 0,020 und 0,040 dm³/m², insbesondere zwischen 0,023 und 0,038 dm³/m².

Bevorzugte Porendurchmesser sind 0,5-5 $\mu$m, insbesondere 1-2 $\mu$m. Bevorzugte Porentiefen sind 0,5-2,5 $\mu$m.

Im Vergleich zu ebenfalls bekannten "Semiadditiv-Methoden", die durch das Auflaminieren von galvanisch hergestellten Dünnschichtauflagen oder durch das chemische Abscheiden von Metallen mit Hilfe einer kautschukhaltigen Haftvermittlerauflage charakterisiert sind, zeichnet sich die Herstellung der neuen Leiterplatten durch einen geringeren Arbeitsaufwand sowie verbesserte mechanische, thermische und electrische Eigenschaften des polymeren Basismaterials aus.

Das Verfahren zur Herstellung von Leiterplatten ist dadurch gekennzeichnet, daß man das Basismaterial mit der oben spezifizierten Oberflächenbeschaffenheit mit einem organometallischen Aktivatorsystem der angegebenen Art behandelt, gegebenenfalls mit einem Reduktionsmittel sensibilisiert, die so erhaltenen Halbzeuge in einem naßchemischen Metallisierungsbad ganzflächig oder partiell metallisiert und anschließend die Leiterplatten nach den bekannten Prinzipien der Semi-oder Volladditiv-Technik fertigstellt.

In einer besonderen Ausführung des erfindungsgemäßen Verfahrens werden zur Erhöhung der Prozeßsicherheit die so behandelten Leiterplattenbasismaterialien bei einer Temperatur von 50°C bis zum Zersetzungsbereich vorzugsweise im Bereich der Erweichungstemperatur getempert.

Zur Erzeugung der erfindungsgemäßen Oberflächenbeschaffenheit sind sowohl physikalische Methoden (z.B. spezielle Sandstrahltechniken oder Laserbestrahlung) als auch chemische Verfahren - (z.B. Behandlung mit selektiv wirksamen Lösungsmitteln) geeignet. Eine andere Variante zur Erzeugung dieser Oberflächen besteht darin, daß metallkaschierte Basisplatten auf chemischem Wege in einem Redoxbad (siehe beispielsweise G. Herrmann et al. "Leiterplatten, Herstellung und Verarbeitung", S. 103 bis 108, G. Leuze Verlag, Saulgau/Württ. 1978) oder auf elektrisch-galvanischem Wege von ihrer Kaschierung befreit werden, worauf sich automatisch die erfindungsgemäße Oberflächenstruktur einstellt.

Bei den als Ausgangsmaterialien verwendeten metallisierten Basisplatten handelt es sich vor allem um beidseitig metallkaschierte, vorzugsweise unter Verwendung von Elektrolytkupferfolien kaschierte handelsübliche Plattenmaterialien, für die Subtraktiv-Technik, die durch die Normgrößen FR-2, FR-3, FR-4, FR-5, G-10 und G-11 charakterisiert sind under weiter unten näher beschrieben sind.

Zur Ablösung der Metallkaschierung sind wohl saure als auch neutrale und alkalische Redoxbäder geeignet. Beispielsweise seinen salz-oder - schwefelsäurehaltige Redox systeme auf Basis von $H_2O_2$, $ClO_3^-$ und $Fe^{3+}$ sowie ammoniakalkalische natriumchlorit-und ammoniumpersulfathaltige Redoxsysteme erwähnt. Auch andere Redoxsysteme, die eine Abätzung der Metallauflage bewirken, können zur Durchführung des Verfahrens eingesetzt werden, vorausgesetzt, daß die Kunststoffoberfläche vom eingesetzten Redoxbad nicht angegriffen wird. Aus diesem Grunde sollen die üblichen aggressiven Kunststoffbeizbäder auf der Basis von Chromschwefelsäure möglichst vermieden werden, zumal diese auch die physikalischen Eigenschaften des Trägermaterials beeinträchtigen.

Optimale Oberflächenstrukturen werden erzielt, wenn man von einem Plattenmaterial ausgeht, das mit galvanisch erzeugten Metallfolien kaschiert worden ist.

Solche Metallfolien weisen nämlich eine besondere Porosität auf, die beim Kaschieren auf den polymeren Trägerwerkstoff für die Erzeugung der speziellen Oberflächenbeschaffenheit der Basismaterialien maßgeblich verantwortlich ist.

Die Porositätbildung kann dadurch gefördert werden, daß man den Galvanisierungsbädern Komplexbildner auf der Basis von Cadmium, Selen und Tellur zusetzt oder nachträglich die Elektrolytfolie auf chemischem oder mechanischem Wege aufrauht.

Die Herstellung von solchen durch eine poröse Oberflächengestalt (Topografie) charakterisierten Metall-(vorzugsweise Kupfer-)-folien ist vielfach in der Literatur beschrieben worden. In diesem Zusammenhang seien erwähnt: "Metalloberfläche" Band 31 (12), 563 (1977), Band 38 (10), 439 ff (1984) und Band 38 (3), 103 ff (1984) sowie folgende Patentliteratur DE-A 2 235 522, DE-A 2 249 796, DE-A 2 500 160, DE-B 1 496 748, US 3 220 897, US 3 328 275, US 3 580 010 und US 3 227 636. Gemäß Verfahren der letztgenannten US-Patentschrift erhält man poröse Metall(Kupfer)-Folien, deren poröse Seite eine besonders wirksame Metall/Metalloxid-Struktur aufweist.

Im übrigen können neben derartigen Metallfolien auch wärmeformbeständige Trennfolien zur Übertragung der gewünschten Porenstruktur auf die Basismaterialien verwendet werden. Derartige Trennfolien mit Erweichungspunkten von 150 bis 400°C sind bekannt und bestehen z. B. aus Polyhydantoinen, aromatischen Polyester-, Polyamid-und Polyimid-Typen (sowie deren Mischungen) und aus fluorhaltigen Polymeren.

Geeignete Metallfolien leiten sich grundsätzlich von allen gängigen galvanisch abscheidbaren Metallen ab, wie Co, Ni, Pt, Pd, Ag, Al und vor allem Au und insbesondere Cu sowie deren Mischungen (vgl. z. B. "Plating", 52, 228-232 (1965)).

Beispielsweise geht man bei der Herstellung der metallkaschierten Plattenmaterialien wie folgt vor:

Die mit Harzvorprodukt und Härter getränkten Glasmatten werden bei erhöhter Temperatur zwischen zwei porösen Metallfolien verpreßt. Dabei empfiehlt es sich, die Harzmasse im heißen Preßwerkzeug etwas verhärten zu lassen, bevor der ganze Schließdruck angewandt wird, damit das dünnflüssige Harz nicht seitlich ausgepreßt wird.

Nach dem Abbeizen der Metallkaschierung erhält man auf dem polymeren Trägerwerkstoff eine Oberflächenstruktur, die in ihren Dimensionen der des erfindungsgemäß zu verwendenden Basismaterials entspricht.

Zur Erzeugung der erfindungsgemäßen Oberflächen, durch Sandstrahlen soll das Pulvermaterial eine mittlere Körnung von 0,1-10 $\mu$m, vorzugsweise 5-7 $\mu$m aufweisen. Pulvermaterialien auf Basis von Quarz, Korrund und Diamant sind zur Durchführung des Verfahrens gut geeignet. Um einen chemischen Abbau des polymeren Basismaterials zu vermeiden, kann selbstverständlich das Sandstrahlen unter Inertgasatmosphäre vorgenommen werden.

Vorzugsweise kann die zur Durchführung des erfindungsgemäßen Verfahrens geeignete poröse Oberflächenstruktur nach den bekannten Membranherstellungsmethoden erzielt werden (vgl. beispielsweise DE-A 24 31 071, US 4 286 015, DE-A 32 05 289 und GB 2 030 843). Hierbei wird bekannterweise das polymere Basismaterial mit einer Lösung aus Präpolymeren oder Polymeren, welche bezüglich ihrer chemischen Beschaffenheit mit dem Basismaterial identisch sind, in Lösungsmittelgemischen unterschiedlicher Flüchtigkeit, die gegebenenfalls Quellmittel und Porenbildner enthalten, benetzt. Das leicht flüchtige Lösungsmittel wird teilweise verdampft, und anschließend wird das Koagulierungs-bzw. Füllungsmittel beispielsweise unter Vakuum der Polymermatrix entzogen.

Das "flächenbezogene, spezifische Gesamtporenvolumen" ist das Produkt aus dem spezifischen Gesamtporenvolumen ($cm^3/g$) und der flächenbezogenen Masse ($g/m^2$) der Basismaterialien, d.h.

$$[cm^3/g] \bullet [g/m^2] = [cm^3/m^2] \text{ bzw. } [10^{-3} \bullet dm^3/m^2]$$

Die Definition des spezifischen Gesamtporenvolumens von Feststoffoberflächen findet man in Angew. Chem. <u>84</u>, S. 331-336 (1972).

Unter "mittlerer Porentiefe" und "mittlerem Porendurchmesser" sind die Mittelwerte (unter Berücksichtigung der Gauß'chen Normalverteilung) der mit dem Rasterelektronenmikroskop ermittelten Porenabmessungen zu verstehen.

Bei Aktivatoren handelt es sich vor allem um kolloidale Systeme von metallischem Pd, Pt, Au und Ag, die gegebenenfalls darüber hinaus hydrolysierbare Verbindungen von Elementen der 3. und 4. Haupt-und Nebengruppen des Periodensystems (z.B. Si, Ti, Ta, Zn, Sn, Zr und Al) enthalten können.

Solche Aktivierungssysteme sind z.T. im Fachhandel erhältlich und im übrigen vielfach in der Literatur beschrieben werden (vgl. z.B. "Kunststoffgalvanisierung" von R. Weines, Eugen Leuze Verlag, Saulgau/Württemberg (1979), Seiten 180-209.)

Bevorzugt sind Pd-und Pd/Sn-Systeme.

Geeignete anorganische Verbindungen der Elemente der 1. und 8. Nebengruppe sind

a. Verbindungen der Formel

$$Me^{n+} E^{m+} Hal_z^-$$

worin Me für Wasserstoff-, Alkali-oder Erdalkaliatome bzw. Schwermetallatome (Fe, Co, Ni oder Cu) oder für $NH_4$, Hal für Halogen - (vorzugsweise Cl und Br) und E für ein Edelmetallatom der 1. oder 8. Nebengruppe des Periodensystems, (vorzugsweise Pt, Pd und Au) mit der Wertigkeit m bzw. n und der Koordinationszahl z steht, wobei z-m = n ist, oder

b. aus nichtkomplexe Salze dieser Elemente der Formel

$$E^{m+} Hal_p^-$$

Bevorzugt anzuwendende Edelmetallverbindungen sind solche der Formel $H_2PdCl_4$, $Na_2(PdCl_2Br_2)$, $Na_2PdCl_4$, $Ca\ PdCl_4$, $Na_4(PtCl_6)$, $AgNO_3$, $HAuCL_4$, $CuCl_2$ und $CuCl$. Bevorzugt sind die Pd-Verbindungen.

Die Aktivatoren können in Konzentrationsbereichen von 0,001 g/l (bezogen auf das Edelmetall) bis hin zur jeweiligen Löslichkeitsgrenze eingesetzt werden. Vorzugsweise arbeitet man mit 0,1 bis 3,0 g/l dieser Substanzen.

Bei der praktischen Durchführung der Aktivierung geht man im allgemeinen so vor, daß man die zu metallisierenden Basisträger mit dem Aktivatorsystem in einem geeigneten organischen oder vorzugsweise anorganischen Lösungsmittel benetzt, das Lösungsmittel entfernt und ge gebenenfalls mit einem geeigneten Reduktionsmittel sensibilisiert. Danach kann der so vorbehandelte Träger in einem üblichen Metallisierungsbad metallisiert werden.

Als Reduktionsmittel für die Sensibilisierung eignen sich Aminoborane, Alkalihypophosphite, Alkylborhydride, Hydrazinhydrat und Formalin. Das Benetzen der Substrate kann durch Besprühen, Bedrucken, Tränken oder Imprägnieren erfolgen.

Eine ganz besonders bevorzugte Ausführungsform der Aktivierung besteht darin, daß die Reduktion im Metallisierungsbad gleich mit dem Reduktionsmittel der stromlosen Metallisierung durchgeführt wird.

Diese Ausführungsform ist ganz besonders für aminboranhaltige Nickelbäder oder formalinhaltige Kupferbäder geeignet.

Als in dem erfindungsgemäßen Verfahren einsetzbare Metallisierungsbäder kommen handelsübliche heiße und kalte Bäder von Nickelsalzen, Cobaltsalzen, Kupfersalzen, Gold- und Silbersalzen oder deren Gemische in Betracht, wobei die Cu-Bäder ganz besonders zu bevorzugen sind.

Für eine gegebenenfalls durchzuführende galvanische Verstärkung kommen folgende Metalle in Frage:

Ni, Co, Cu, Ag, Al, Cr und Au. Bevorzugt ist Cu, Au und Ni, ganz besonders bevorzugt ist Cu.

Um gegebenenfalls die Haftung der auf der erfindungsgemäßen Kunststoffoberfläche abgeschiedenen Metallauf lage zu erhöhen bzw. um eine 100 %ige Prozeßsicherheit zu gewährleisten, kann eine Temperung vorgenommen werden. Bemerkenswert ist, daß die Temperung überraschenderweise im Gegensatz zu den anderen Verfahren (siehe beispielsweise DE-A 32 42 162 und US 4 327 126) an bereits endgehärteten Platten vorgenommen wird, was das Verfahren universell anwendbar, d.h. von der Lagerzeit des Trägermaterials unabhängig macht.

Die Temperungstemperatur kann im breiten Bereich von 50°C bis zum jeweiligen Zersetzungsbereich des polymeren Basismaterials variiert werden, wobei für das FR-4 -Material die Temperaturen von 125°C-180°C insbesondere der Erweichungsbereich des polymeren Basismaterials und für das FR-2 und FR-3 die Temperaturen von 80°C-130°C insbesondere der Erweichungsbereich zu bevorzugen sind. Die Temperungszeiten können zwischen 5 Minuten bis 10 Stunden variiert werden, wobei die Zeiten 10 bis 60 Minuten besonders zu bevorzugen sind. Um einen Abbau des Basismaterials zu vermeiden, kann die Temperung unter Inertgas vorgenommen werden.

Selbstverständlich kann die Temperung auch nach der galvanischen oder chemischen Verstärkung der Metallauflage auf die gewünschte Schichtdicke vorgenommen werden.

Bevorzugte Kunststoffe zur Herstellung der Basisplatten sind härtbare duroplastische Materialien (englisch: thermosetting resins) wie Phenol-, Epoxid-, Melamin- und Polyesterharze, wobei die Phenol- bzw. Epoxidharze (FR-2, FR-3, FR-4, und FR-5) ganz besonders bevorzugt eingesetzt werden.

Die duroplastischen Substrate können mit Verstärkungsmaterialien, wie mit Glas-, Mineral-, Kohle- und Aramid-Fasern bzw. -Matten und deren Gemische untereinander, verstärkt werden.

Die aus diesen Basismaterialien durch Aktivieren und gegebenenfalls Anbringen von Bohrlöchern erhältlichen sogenannten Halbzeuge, sowie die daraus hergestellten Leiterplatten weisen überraschenderweise folgende gute Eigenschaften auf:

1. Sie sind an der Luft gegenüber Feuchtigkeit, Witterungs- und Wärmeeinflüsse stabil.

2. Ihre Aktivatorauflage ist nicht während des Aufbringens bzw. des Entwickelns von Fotoresistauflagen von der Oberfläche entfernbar. Sie läßt sich problemlos mit Hilfe von bekannten Oberflächenanalysemethoden, wie ESCA, nachweisen.

3. Die Abzugsfestigkeit der Metallauflagen nach DIN 53 494 beträgt mindestens 22,5, vorzugsweise jedoch 30-35 N/25 mm und in vielen Fällen größer als 50 N/25 mm.

4. Bei der Sensibilisierungs bzw. Metallisierung tritt keine Vergiftung der Metallisierungs- oder Sensibilisierungsbäder ein.

Diese Vorzüge weisen solche Halbzeuge bzw. Leiterplatten, die ausgehend von mit nicht-elektrolytisch abgeschiedenen Metallfolien kaschierten Basisträgern für die Additivtechnik hergestellt werden, nicht oder in wesentlich geringerem Maße auf.

Die Oberflächen der "Halbzeuge" können mit einer leicht abziehbaren Alu- oder Kunststoff-Folie versehen werden. Besonders die Alufolie dient als Bohrhilfe und schützt die Substratoberfläche vor äußeren Einflüssen.

Die erfindungsgemäßen Leiterplatten sind zur Herstellung von ein- oder mehrlagigen gedruckten Schaltungen aller Art geeignet. Vorzugsweise werden durchkontaktierte gedruckte Schaltungen hergestellt.

Beispiel 1

15 g methanolische K₂PtCl₆-Lösung (Pt-Gehalt etwa 1,75 Gew. -%) werden mit 1 l einer Lösung von 5 ml HC1 (37 %ig) und 2,5 g SnCl₂ in destilliertem Wasser bei 45°C versetzt. Man rührt dann 45 Minuten nach und erhält eine dunkel gefärbte homogene Aktivierungslösung. Mit dieser Lösung werden nach Beispiel 2 mit Poren versehene, glasmattenverstärkte Epoxidharzplatten (200 x 200 x 2 mm) 5 Min. behandelt. Eine so aktivierte Platte wird in einem Sensibilisierungsbad, welches pro Liter 20 ml NH₂-NH₂, 12 ml NH₃ (25 %ig) enthält, 7,5 Min. sensibilisiert und dann in einem handelsüblichen Verkupferungsbad bei 80°C 45 Min. metallisiert und anschließend unter Heliumatmosphäre bei 195°C 90 Minuten lang nachgetempert. Man bekommt eine mit einer gut haftenden, ~0,7 μm star-

ken Cu-Auflage versehene Platte, die sich nach einer partiellen Maskierung mit einem handelsüblichen Photolack, nach galvanischer Verstärkung der freien Bahnen und anschließender Befreiung der Plattenoberfläche vom Photolack bzw. von der darunter befindlichen Cu-Auflage zu einer lötbaren, herkömmlichen Leiterplatte verarbeiten läßt.

Die so hergestellten Leiterplatten lassen sich problemlos mit herkömmlichen Lötsystemen löten und bestehen den branchenüblichen Temperaturwechseltest.

Beispiel 2

Eine durch Diamantstrahlen (mittlere Korngröße ~4 μm) an der Oberfläche mit Poren versehene handelsübliche glasmattenverstärkte Epoxidharzplatte (200 x 40 x 1 mm) (FR-4-Qualität) mit einer flächenbezogenen spezifischen Gesamtporenvolumen von 0,018 dm³/m² wurde in einer Lösung bestehend aus 0,25 g $Na_2PdCl_4$ und 1000 ml Methanol 5 Min. behandelt, in einem Bad bestehend aus 500 ml $H_2O_{dest.}$, 5 ml $NH_3$ (25 %ig reinst) und 2 g DMAB (Dimethylaminboran) 5 Min. sensibilisiert, gewaschen und dann in einem handelsüblichen Verkupferungsbad 60 Min. verkupfert. Die Platte wurde anschließend in einem Trockenschrank unter $N_2$-Atmosphäre bei 170°C 45 Min. getempert.

Man erhält ein Polymer-Metall-Verbundmaterial mit gut haftender lötbadbeständiger Metallauflage. Es ist zur Herstellung von gedruckten Schaltungen geeignet.

Beispiel 3

Eine durch Korundstrahlen (mittlere Korngröße 2,5 μm) an der Oberfläche mit Poren versehen handelsübliche glasmattenverstärkte Epoxidharzplatte (200 x 40 x 1 mm), (mit einer flächenbezogenen spezifischen Gesamtporenvolumen von ~0,02 dm³/m²) (FR-4 Qualität) wird gebohrt und dann in einer Lösung aus 1 g $HAuCl_4$-Komplexverbindung in 1000 ml nachgereinigtem Aceton 7,5 Min. behandelt.

Die so vorbereitete Platte wird in einem Bad, bestehend aus 750 ml $H_2O$, 5 g NaOH (fest) und 15 ml Hydrazinhydrat, 3,5 Min. sensibilisiert, dann in einem handeltsüblichen chemischen Cu-Bad bei 75°C mit einer ~ 1,0 μm starken Cu-Auflage versehen, mit einem handelsüblichen UV-härtbaren Siebdrucklack mit einer Maske, welche freie kammförmige durchgehende Bahnen von etwa 500 μm aufweist, bedeckt, 25 Minuten bei 230°C getempert und schließlich mit galvanischem Nickel auf ~40 μm verstärkt. Nach der Befreiung des Probekörpers vom Lack bzw. Abätzen der darunterliegenden Cu-Auflage erhält man eine nach herkömmlichen Methoden lötbare durchkontaktierte elektrische Leiterplatte.

Die Metallschicht haftet an der Substratoberfläche so gut, daß sie trotz einer 3minütigen Nachtemperung bei 260°C in einem herkömmlichen Lötbad nicht von der Substratoberfläche zu entfernen ist.

Beispiel 4

Eine mit Glas-und Aramidfasermatten verstärkte Epoxidharzplatte wird mit einer Lösung aus 15 g handelsüblichem Epoxidharzvorprodukt auf Basis von Bisphenol A mit der äquivalenten Menge an aromatischem Härter (Di-aminodiphenylsulfon) in 1000 ml $CH_2Cl_2$ (leicht flüchtige Komponente) und 85 ml N-Methylpyrolidon (schwer flüchtige Komponente) durch Tauchen beschichtet, 2 h bei Raumtemperatur getrocknet. Die so aufgebrachte Vorkondensatauflage wird bei 120°C 20 Min. gehärtet. Dann wird das in der Polymermatrix eingeschlossene n-Methylpyrolidon bei 210°C unter Wasserstrahlvakuum der Polymermatrix entzogen.

Man erhält eine poröse Platte mit einem flächenbezogenen spezifischen Gesamtporenvolumen von 0,034 dm³/m², die sich nach Beispiel 1 zu herkömmlichen Leiterplatten verarbeiten läßt. Die Haftung der Metallauflage ist gut und besteht den Lötbad-bzw. Temperaturwechseltest.

Beispiel 5

Eine in Europa-Format zurechtgeschnittene beidseitig mit Elektrolyt-Kupfer kaschierte Epoxidharzplatte auf FR-4-Material für die Subtraktiv-Technik, z. B. der Firma Isola AG, Düren - (Germany), wird in einer Redox-Lösung bestehend aus 50 ml HCl (37 %ig), 60 ml $H_2O_2$ und 500 ml $H_2O$ von der Cu-Auflage befreit. Man bekommt eine oberflächenporöse Platte mit einem flächenbezogenen spezifischen Gesamtporenvolumen von 0,024 dm³/m². Diese Platte wird in einer Lösung bestehend aus 200 ml Aceton, 800 ml $H_2O_{dest.}$ und 0,8 g $Na_2PdCl_4$ (reinst) im Verlaufe von 3 Minuten aktiviert. Danach wird die Platte 5 Min. in einer Lösung von 5 g Dimethylaminboran in einem 1 l $H_2O$/Methanol-Gemisch (50: 50 Vol. -%) behandelt. Nach kurzem Spülen wird in einem chemischen Verkupferungsbad innerhalb von ca. 30 Min. eine etwa 0,5 μm starke Cu-Auflage aufgetragen. Die chemisch verkupferte Platte wird darauf 1 h bei 160°C getempert, nach Beispiel 4 partiell galvanisch verstärkt und dann von dem Rest-Cu befreit. Man bekommteine lötbare Leiterplatte mit einer sehr guten Metallhaftung.

Beispiel 6

Eine beidseitig kupferbeschichtete, glasmattenverstärkte Epoxidharzplatte (FR-4) wird gebohrt und dann entstaubt. Diese Platte wird durch Abätzen in einer alkalischen 15,7 %igen Natriumchloritlösung (pH~12) von der Cu-Auflage befreit, in 2 %iger $NaHSO_3$-Lösung entgiftet, mit $H_2O$ und Methanol gewaschen und getrocknet. Man bekommt eine an der Oberfläche poröse Platte mit einem flächenbezogenen spezifischen Gesamtporenvolumen von ~0,028 $dm^3/m^2$. Sie wird anschließend 5 Minuten in einer Lösung bestehend aus 1,2 g $Na_2PdCl_4$ (reinst), 1 l nachgereinigtem Methanol und 2,15 g Titansäuretetrabutylester aktiviert, getrocknet und dann in einer Lösung bestehend aus 750 ml $H_2O_{dest.}$ 7,5 g dimethylaminboran und 1,75 g NaOH (fest) sensibilisiert, in einem handelsüblichen formalinhaltigen Verkupferungsbad 55 Minuten verkupfert, mit $H_2O_{dest.}$ gewaschen, im Trockenschrank bei 178°C getempert. Die so mit einer gut haftenden, elektrisch leitenden Metallauflage versehene Probe wird mit einer Siebdruckmaske auf der Basis vom Polybutadien, welche freie rasterförmige Bahnen von etwa 100 μm aufweist, bedeckt und dann die freie Metalloberfläche mit galvanischem Kupfer auf ~ 45 μm verstärkt. Nun wird der Probekörper in Methylethylketon von der Maske befreit und die darunterliegende auf chemischem Wege abgeschiedene Cu-Auflage in einer Lösung aus 500 ml $H_2O_{dest.}$ , 8,5 ml HCl - (reinst 37 %ig) und 18,5 ml $H_2O_2$ abgeätzt.

Man bekommt eine durchkontaktierte, elektrische Leiterplatte mit ~ 100 μm breiten und ~ 44 μm starken Leiterbahnen. Die Metallauflage haftet an der Substratoberfläche so gut, daß sie trotz einer 25minütigen Wärmebelastung bei 225°C nicht von der Substratoberfläche zu entfernen ist. Sie läßt sich nach herkömmlichen Methoden löten.

Beispiel 7

Eine in Europa-Format zurechtgeschnittene beidseitig Cu-kaschierte Epoxidharzplatte aus FR-2 Material wird nach Beispiel 4 von der Cu-Auflage befreit. Man bekommt eine oberflächenporöse Platte mit einem flächenbezogenen spezifischen Gesamtporenvolumen von 0,020 $dm^3/m^2$. Diese Platte wird nach Beispiel 4 metallisiert, 14 min. bei 150°C, 25 min. bei 120°C getempert und dann nach Beispiel 4 weiter verarbeitet. Man bekommt eine Leiterplatte mit guter Metallhaftung. Diese Platte ist nach herkömmlichen Methoden lötbar.

Beispiel 8

Eine herkömmliche Platte aus Phenol-Formalinharz (FR-2) wird nach Beispiel 2 mit Poren versehen, aktiviert, verkupfert, 10 min. bei 150°C und dann 30 min. bei 110°C getempert. Man bekommt eine mit einer ca. 1.0 μm starken, gut haftenden Cu-Auflage versehene Basisplatte, die sich nach dem im Beispiel 6 beschriebenen Verfahren zu einer lötbaren Leiterplatte verarbeiten läßt.

**Ansprüche**

1. Elektrische Leiterplatten bestehend im wesentlichen aus dem Basismaterial und dem naßchemisch unter Verwendung von Aktivatorsystem, nach den Prinzipien der Semi-oder Volladditivtechnik aufgebrachten Leiterbild, dadurch gekennzeichnet, daß die Aktivatoren fein verteilte Metalle oder anorganische ionogene Verbindungen von Elementen der 1. oder 8. Nebengruppe des periodischen Systems sind und daß die Oberfläche des Basismaterials charakterisiert ist durch.

　　　a) ein flächenbezogenes spezifisches Gesamtporenvolumen von 0,015-0,045 $dm^3/m^2$
　　　b) einen mittleren Porendurchmesser von 0,05-12,0 μm und
　　　c) eine mittlere Porentiefe von 0,05-12,0 μm.

2. Elektrische Leiterplatten gemäß Anspruch 1, dadurch gekennzeichnet, daß die Aktivatoren fein verteilte Systeme von Pt, Pd, Au, Rh und Ag oder deren anorganische ionogene Verbindungen sind.

3. Elektrische Leiterplatten gemäß Anspruch 1, dadurch gekennzeichnet, daß
　　　a) das Porenvolumen 0,020-0,040 $dm^3/m^2$,
　　　b) der Porendurchmesser 1-2 μm und
　　　c) die Porentiefe 0,5-2,5 μm betragen.

4. Verfahren zur Herstellung von Leiterplatten, dadurch gekennzeichnet, daß man Basismaterialien mit der in Anspruch 1 charakterisierten Oberflächenbeschaffenheit mit einem anorganischen, ionischen oder kolloidalen Aktivatorsystem der in Anspruch 1 angegebenen Art behandelt, gegebenenfalls sensibilisiert, die so erhaltenen Halbzeuge naßchemisch ganzflächig oder partiell metallisiert und die Leiterplatten in üblicher Weise fertigstellt.

5. Verfahren gemäß Anspruch 4, dadurch gekennzeichnet, daß man die charakteristische Oberflächenbeschaffenheit durch Sandstrahlen oder Schleifen der Basismaterialien erzeugt.

6. Verfahren zur Herstellung von Leiterplatten, dadurch gekennzeichnet, daß man Basismaterialien beiseitig mit einer elektrolytisch erzeugten Metallfolie kaschiert, die Kaschierung chemisch in einem Redoxbad oder elektrogalvanisch ablöst, die so vorbehandelten Basismaterialien mit dem Aktivatorsystem aktiviert, gegebenenfalls sensibilisiert und auf den so erhaltenen Halbzeugen durch Anwendung einer Semi-oder Volladditivtechnik die Leiterbilder aufbringt.

7. Verfahren nach Anspruch 6, dadurch gekennzeichnet, daß man als Metallfolie eine galvanisch hergestellte Kupferfolie verwendet.

8. Verfahren nach Anspruch 1,5 oder 6, dadurch gekennzeichnet, daß die Porenstruktur der Metallfolien hinsichtlich ihrer Dimensionen der des gemäß Anspruch 1 gekennzeichneten Basismaterials entspricht.

9. Verfahren nach Anspruch 4 oder 6, dadurch gekennzeichnet, daß zur Verbesserung der Haftfestigkeit der Metallauflagen eine Temperung im Bereich von 50°C bis zum Zersetzungspunkt des Basismaterials vorgenommen wird.

10. Verwendung der Leiterplatten gemäß Anspruch 1 bzw. erhalten gemäß Verfahren der Ansprüche 4 und 6 zur Herstellung von durchkontaktierten gedruckten Schaltungen.